# EUROPEAN PATENT APPLICATION

(11) **EP 4 525 225 A1**
(43) Date of publication of application: **19.03.2025**
(21) Application number: 23802511.8
(22) Date of filing: 24.03.2023
(51) Int. Cl.: H01S 5/125

(54) **SEMICONDUCTOR LASER DEVICE AND PREPARATION METHOD THEREFOR**

(30) Priority: 10.05.2022 CN 202210501840
(71) Applicant: Innolight Technology (Suzhou) Ltd., Suzhou, Jiangsu 215000 (CN)
(72) Inventor: CHENG, Ning, Suzhou, Jiangsu 215000 (CN)
(74) Representative: Becker, Eberhard
(86) International application number: PCT/CN2023/083802
(87) International publication number: WO 2023/216735

(57) **Abstract**

A high-speed directly modulated semiconductor laser device and a preparation method therefor. The semiconductor laser device comprises an optical waveguide (1) and an optical grating (2), which is formed by means of a one-step etching process, wherein the optical grating (2) comprises a first optical grating portion (21) and a second optical grating portion (22), which are arranged side by side. The first optical grating portion (21) and the second optical grating portion (22) can effectively control a lasing wavelength and a photon-photon resonance frequency, and generate a load mismatch resonance effect, such that a relatively high yield can be realized while effectively improving the modulation bandwidth of the directly modulated semiconductor laser device, and an FP cavity is prevented from being formed from the reflection of front and rear end faces of the laser device, and thus multi-longitudinal-mode oscillation generated by the laser device at a high temperature or low temperature is prevented.

## Description

This application claims the priority benefit of China application filed on May 10, 2022, no. 202210501840.0, with the title of invention being "SEMICONDUCTOR LASER DEVICE AND PREPARATION METHOD THEREFOR". The entirety of the above-mentioned patent applications is hereby incorporated by reference herein and made a part of this specification.

### Technical Field

The present disclosure relates to the field of optical communications, and in particular to a semiconductor laser device and a preparation method therefor.

### Related Art

Compared to externally modulated laser devices, directly modulated semiconductor laser devices offer higher output power, lower production costs, and reduced power consumption. Consequently, directly modulated semiconductor laser devices with high bandwidth and low chirp have consistently been a focal point of research in optical communications.

The bandwidth of conventional semiconductor laser devices is limited by the device's RC constant and the relaxation oscillation frequency of carrier-photon interactions, with a maximum bandwidth of approximately 30 GHz. To further enhance the modulation bandwidth of directly modulated semiconductor laser devices, relevant technologies are considering the adoption of shorter cavity lengths and larger optical confinement factors, or the utilization of physical effects such as photon-photon resonance, load mismatch resonance, and amplitude modulation (AM) to frequency modulation (FM) conversion. However, the pressing issue that needs to be addressed is how to effectively increase the modulation bandwidth of directly modulated semiconductor laser devices while simultaneously achieving a high yield rate.

### SUMMARY OF INVENTION

### Technical Problem

Based on the foregoing, it is necessary to provide a directly modulated semiconductor laser device that effectively enhances the modulation bandwidth of the directly modulated semiconductor laser device while achieving a high yield rate. Concurrently, it is essential to prevent the formation of a FP cavity due to reflections from the front and rear facets of the laser device, which could lead to multi-longitudinal mode oscillations in the laser device at high or low temperatures.

### Technical Solution to Problem

According to one aspect of an embodiment of the present disclosure, a semiconductor laser device is provided. The semiconductor laser device includes an optical waveguide and an optical grating disposed on one side of the optical waveguide. The optical grating includes a first optical grating portion and a second optical grating portion disposed side by side.

In an embodiment of the present disclosure, an optical grating formed jointly by a first optical grating portion and a second optical grating portion is disposed on one side of the optical waveguide. This configuration enables the utilization of both the first optical grating portion and the second optical grating portion to collectively determine the lasing wavelength and the photon-photon resonance frequency of the semiconductor laser device. This arrangement facilitates effective control of the lasing wavelength of the semiconductor laser device at the long-wavelength edge of the reflection spectrum of the first optical grating, while simultaneously maintaining precise control of the photon-photon resonance frequency within a narrow range. Specifically, the second optical grating portion plays a primary role in determining the lasing wavelength of the semiconductor laser device. Concurrently, the first optical grating portion is employed to induce a load mismatch resonance effect when the lasing wavelength of the semiconductor laser device is positioned at the long-wavelength edge of the reflection spectrum of the first optical grating portion. This load mismatch resonance effect serves to effectively enhance the bandwidth of the directly modulated semiconductor laser device. Furthermore, the present disclosed embodiment enables the enhancement of the bandwidth of the directly modulated semiconductor laser device through precise control of the photon-photon resonance frequency.

Furthermore, in an embodiment of the present disclosure, the first optical grating portion and the second optical grating portion disposed side by side have different coupling coefficients and are formed by etching once on an optical grating material layer with uniform thickness.

Based on the foregoing, in an embodiment of the present disclosure, through the design of the optical grating structure and simplification of the optical grating etching process, it is possible to effectively enhance the modulation bandwidth of the semiconductor laser device while avoiding other complex process treatments to the semiconductor laser device. Additionally, it is possible to enable precise control of the lasing wavelength and photon-photon resonance frequency of the semiconductor laser device, thereby achieving a relatively high yield rate.

In some embodiments, the length of the first optical grating portion is less than the length of the second optical grating portion. Thus, the second optical grating portion may play a major role in determining the lasing wavelength of the semiconductor laser device, while the first optical grating portion is mainly used to cause the lasing wavelength of the semiconductor laser device to produce a load mismatch resonance effect when being located at the long-wavelength edge of the reflection spectrum of the first optical grating portion.

In some embodiments, a coupling coefficient of the first optical grating portion is greater than a coupling coefficient of the second optical grating portion.

In some embodiments, a period of the first optical grating portion is shorter than a period of the second optical grating portion.

Optionally, the period of the first optical grating portion is short, satisfying the first-order Bragg reflection condition, while the period of the second optical grating portion is long, satisfying the second-order or higher-order Bragg reflection condition. When the thickness of the optical grating material layer is the same, through one-step etching process, the coupling coefficient of the first optical grating portion is different from the coupling coefficient of the second optical grating portion.

In some embodiments, the semiconductor laser device has a light output terminal and a light reflection terminal that are arranged opposite to each other. The semiconductor laser device further includes an anti-reflection film arranged on the end surface of the light output terminal, and a reflection film arranged on the end surface of the light reflection terminal. The two terminals of the optical waveguide are respectively coupled to the anti-reflection film and the reflection film. The first optical grating portion is located on one side of the second optical grating portion close to the reflection film; or the first optical grating portion is located on one side of the second optical grating portion close to the anti-reflection film.

In an embodiment of the present disclosure, there are no reflectivity requirements for the end surface at the light output terminal of the semiconductor laser device. In other words, this semiconductor laser device does not need to utilize the end surface at the light output terminal for optical feedback. Consequently, this disclosed embodiment allows for the application of an anti-reflection film on the end surface at the light output terminal. Even if the optical reflection of the anti-reflection film is zero, the semiconductor laser device may still generate photon-photon resonance through the aforementioned optical grating structure. This approach effectively prevents the formation of a FP cavity due to optical reflection between the end surface at the light output terminal and the end surface at the light reflection terminal of the semiconductor laser device, which could otherwise cause the semiconductor laser device to generate multi-longitudinal mode oscillation at high or low temperatures. The semiconductor laser device provided in this disclosed embodiment may effectively achieve single-longitudinal mode operation.

In some embodiments, there is a gap between the first optical grating portion and the second optical grating portion. The optical waveguide includes a phase shift region. The phase shift region is located in an area overlapping with an orthogonal projection of the gap on the optical waveguide.

Optionally, the phase shift region includes a passive optical waveguide portion.

In an embodiment of the disclosure, a phase shift region is disposed in the optical waveguide, so that the optical signal transmitted by the optical waveguide may be controlled to produce a certain phase shift after passing through the phase shift region, for example, to produce a phase difference of 2kπ+π/2 or a phase difference of other fixed phase values; the phase shift region may more effectively control the operation wavelength of the laser device.

In some embodiments, the optical waveguide includes an active optical waveguide portion and a passive optical waveguide portion coupled to each other. An orthogonal projection of the gap between the first optical grating portion and the second optical grating portion and an orthogonal projection of the second optical grating portion on the optical waveguide are located in a region where the passive optical waveguide portion is located.

In some embodiments, the semiconductor laser device further includes: a first-type electrode layer and a second-type electrode layer disposed opposite to each other; wherein one of the first-type electrode layer and the second-type electrode layer is located on a side of the optical grating away from the optical waveguide, and the other is located on a side of the optical waveguide away from the optical grating.

In an embodiment of the disclosure, current may be injected into the first optical grating portion and the second optical grating portion in the optical grating through the first-type electrode layer and the second-type electrode layer to generate optical gain, thereby improving the light extraction efficiency of the semiconductor laser device.

Optionally, the first-type electrode layer is a P-type electrode layer. The P-type electrode layer includes: a first electrode and a second electrode that are insulated; wherein the orthogonal projection of the first electrode on the optical waveguide at least partially overlaps with the orthogonal projection of the first optical grating portion on the optical waveguide. The orthogonal projection of the second electrode on the optical waveguide at least partially overlaps with the orthogonal projection of the second optical grating portion on the optical waveguide.

In an embodiment of the present disclosure, the first optical grating portion and the second optical grating portion of the optical grating may share the second-type electrode layer. In addition, in an embodiment of the present disclosure, the first-type electrode layer (i.e., the P-type electrode layer) is set as a first electrode and a second electrode relatively independent from each other, and the first electrode may be utilized to control the magnitude of the current injected into the first optical grating portion, and the second electrode may be utilized to control the magnitude of the current injected into the second optical grating portion. In this way, by independently controlling the current injection of the first optical grating portion and the second optical grating portion, the first optical grating portion and the second optical grating portion may be controlled respectively to generate the required optical gain.

Optionally, there is a gap between the first optical grating portion and the second optical grating portion. The P-type electrode layer further includes a third electrode insulated from the first electrode and the second electrode respectively; the orthogonal projection of the third electrode on the optical waveguide at least partially overlaps with the orthogonal projection of the gap on the optical waveguide. In this way, the third electrode may be utilized to control the optical signal transmitted by the optical waveguide to produce some phase shift after passing through the region corresponding to the aforementioned gap.

In some embodiments, the optical waveguide includes a phase modulation portion. The orthogonal projection of the third electrode on the optical waveguide overlaps with the orthogonal projection of the phase modulation portion on the optical waveguide. In this way, the third electrode may be utilized to control the magnitude of the current injected into the phase modulation portion to control the optical signal transmitted by the optical waveguide to produce some phase shift after passing through the phase modulation portion.

In some embodiments, the optical waveguide includes a passive optical waveguide portion. The orthogonal projection of the gap between the first optical grating portion and the second optical grating portion and the orthogonal projection of the second optical grating portion on the optical waveguide are located in the region where the passive optical waveguide portion is located. The orthogonal projections of the third electrode and the second electrode on the optical waveguide are located in the region where the passive optical waveguide portion is located.

According to another aspect of the embodiments of the present disclosure, a method for preparing a semiconductor laser device is provided. The preparation method includes: forming an optical grating material layer with a uniform thickness on one side of an optical waveguide, and forming a first optical grating portion and a second optical grating portion arranged side by side through a one-step etching process, wherein the first optical grating portion and the second optical grating portion together constitute an optical grating, and the coupling coefficient of the first optical grating portion is greater than the coupling coefficient of the second optical grating portion.

Optionally, a period of etching the first optical grating portion is shorter than a period of etching the second optical grating portion.

Optionally, a duty ratio of etching the first optical grating portion is different from a duty ratio of etching the second optical grating portion.

Optionally, a depth of etching the first optical grating portion is greater than a depth of etching the second optical grating portion.

### Beneficial Effects

In an embodiment of the disclosure, a first optical grating portion and a second optical grating portion having different lengths, different coupling coefficients, different periods, etc. may be manufactured through a one-step etching process. Moreover, the manufacturing method is able to strictly control the phase shift between the first optical grating portion and the second optical grating portion, thereby solving the problem of uncontrollable phase shift error caused by different etching processes for optical gratings with different performances in the related art, so as to improve the yield rate of semiconductor laser devices.

### BRIEF DESCRIPTION OF THE DRAWINGS

To provide a clearer explanation of the technical solutions in embodiments of the present disclosure or in conventional technology, a brief introduction to the drawings required in the description of the embodiments or conventional technology will be provided below. It is evident that the drawings described below are merely some embodiments of the present disclosure. Those skilled in the art may obtain other drawings based on these drawings without exerting creative effort.
FIG. 1 is a schematic diagram of the corresponding changes between lasing wavelength and optical grating phase in a semiconductor laser device provided in the related art.
FIG. 2 is a schematic diagram of the corresponding changes between the photon-photon resonance frequency and the optical grating phase in a semiconductor laser device provided in the related art.
FIG. 3 is a schematic structural diagram of a semiconductor laser device provided in an embodiment.
FIG. 4 is a schematic diagram of coupling coefficients corresponding to first-order optical grating and third-order optical grating under various material thicknesses provided in an embodiment.
FIG. 5 is a schematic structural diagram of another semiconductor laser device provided in an embodiment.
FIG. 6 is a schematic structural diagram of yet another semiconductor laser device provided in an embodiment.
FIG. 7 is a schematic structural diagram of still another semiconductor laser device provided in an embodiment.
FIG. 8 is a schematic structural diagram of still another semiconductor laser device provided in an embodiment.
FIG. 9 is a schematic structural diagram of still another semiconductor laser device provided in an embodiment.
FIG. 10 is a schematic structural diagram of still another semiconductor laser device provided in an embodiment.
FIG. 11 is a schematic structural diagram of still another semiconductor laser device provided in an embodiment.
FIG. 12 is a schematic structural diagram of still another semiconductor laser device provided in an embodiment.
FIG. 13 is a schematic structural diagram of still another semiconductor laser device provided in an embodiment.
FIG. 14 is a reflection spectrum diagram of a first optical grating portion and a second optical grating portion in a semiconductor laser device provided in an embodiment.
FIG. 15 to FIG. 30 are optical grating reflection spectra of a semiconductor laser device provided in some embodiments at various optical grating phases.
FIG. 31 is a schematic diagram of the corresponding changes between lasing wavelength and optical grating phase in a semiconductor laser device provided in an embodiment.
FIG. 32 is a schematic diagram showing the corresponding changes between the photon-photon resonance frequency and the optical grating phase in a semiconductor laser device provided in an embodiment.

### Description of reference numerals:

1 - optical waveguide, PS- phase shift region, 11 - passive optical waveguide portion, 12 - active optical waveguide portion,
110 - light transmitting layer, 111 - first-type confinement layer, 112 - second-type confinement layer,
2 - optical grating, 21-first optical grating portion, 22 - second optical grating portion, 23 - gap,
31 - anti-reflection film, 32 - reflection film,
**41** - first-type electrode (P-type electrode), 411 - first electrode, 412 - second electrode, 413 - third electrode,
42 - second-type electrode (N-type electrode), 51 - first-type coating layer, 52 - second-type coating layer.

### DESCRIPTION OF THE EMBODIMENTS

In order to facilitate understanding of the present disclosure, the present disclosure will be described more thoroughly below with reference to the relevant drawings. Embodiments of the present disclosure are given in the drawings. However, the present disclosure can be implemented in many different forms and is not limited to the embodiments described herein. On the contrary, the purpose of providing these embodiments is to make the disclosure of the present disclosure more thorough and comprehensive.

Unless otherwise defined, all technical and scientific terms used herein have the same meaning as those commonly understood by those skilled in the art in the art of the present disclosure. The terms used herein in the specification of the present disclosure are only for the purpose of describing specific embodiments and are not intended to limit the present disclosure.

It should be understood that when an element is referred to as being "connected" or "coupled" to another element, it may be directly connected or coupled to the other element, or there may be intervening elements. Conversely, when an element is referred to as being "directly connected to" or "directly coupled to" another element, there are no intervening elements.

It should be understood that although the terms first, second, third, etc. can be used to describe various elements, components, regions, layers and/or parts, these elements, components, regions, layers and/or parts should not be limited by these terms. These terms are only used to distinguish an element, component, region, layer or part from another element, component, region, layer or part. Therefore, without departing from the teachings of the present disclosure, the first element, component, region, layer or part discussed below can be represented as a second element, component, region, layer or part.

When used herein, the singular forms "a", "an", and "said/the" may also include plural forms, unless the context clearly indicates otherwise. It should also be understood that the terms "include/comprise" or "have" and the like specify the presence of stated features, wholes, steps, operations, components, parts, or combinations thereof, but do not exclude the possibility of the presence or addition of one or more other features, wholes, steps, operations, components, parts, or combinations thereof. At the same time, in this specification, the term "and/or" includes any and all combinations of the relevant listed items.

In recent years, driven by the explosive growth of internet traffic and applications such as cloud storage and distributed computing, data center transmission rates are expected to upgrade from 100G per wavelength to 400G or even 800G in the coming years. Consequently, high-bandwidth optical modulators have become a critical technology for data center optical interconnects. Currently, external modulators based on lithium niobate and silicon have achieved modulation rates of 50 Gbaud or even 100 Gbaud. However, compared to directly modulated semiconductor laser devices, external modulation laser devices exhibit lower optical output power, higher costs, and greater power consumption. Therefore, high-bandwidth, low-chirp directly modulated semiconductor laser devices continue to be a focal point of research in optical communications.

The bandwidth of conventional semiconductor laser devices is limited by the device's RC constant and the relaxation oscillation frequency of carrier-photon interactions, with a maximum bandwidth of approximately 30 GHz. In order to further enhance the modulation bandwidth of directly modulated semiconductor laser devices, one may employ shorter cavity lengths and larger optical confinement factors, or utilize physical effects such as photon-photon resonance, load mismatch resonance, and amplitude modulation to frequency modulation conversion.

In some exemplary cases, a 50µm-long Distributed Feedback (DFB) laser device wafer is bonded to Silicon Carbide (SiC), resulting in a significant enhancement of the optical confinement factor. This configuration achieves a relaxation oscillation frequency of 40GHz, a photon-photon resonance frequency of 95GHz, and a modulation bandwidth of 108GHz.

In some examples, the directly modulated laser device employs a DFB+Reflector (R) structure, which may utilize photon-photon resonance, load mismatch resonance, and amplitude modulation (AM) to frequency modulation (FM) conversion to achieve a modulation bandwidth of 65GHz to 75GHz.

However, the process of bonding DFB wafers to SiC wafers is highly complex and may result in diminished light output power of the laser device. Furthermore, the directly modulated laser device employing a DFB+R structure necessitates stringent control of the lasing wavelength and photon-photon resonance frequency, which may adversely affect the yield rate of the actual devices.

Furthermore, with respect to directly modulated laser devices employing a DFB+R structure, in order to achieve bandwidth enhancement through photon-photon resonance frequency, the photon-photon resonance frequency must be strictly controlled within a specific range. This is due to the fact that photon-photon resonance frequencies that are either excessively high or low are incapable of effecting bandwidth enhancement. The load mismatch resonance effect necessitates that the lasing wavelength of the laser device be positioned at the long-wavelength edge of the reflection spectrum of the optical grating. Consequently, rigorous control of the lasing wavelength is imperative. However, in practical applications of single-longitudinal-mode semiconductor laser devices, it is necessary to apply a High Reflectivity (HR) film to the rear end surface. This results in variations of the lasing wavelength of the laser device in accordance with changes in the phase of the end surface of the optical grating, particularly the phase of the optical grating at the HR end surface. As a result, the load mismatch resonance effect cannot be guaranteed. For instance, when the lasing wavelength exceeds the central wavelength of the reflection spectrum, the lasing wavelength is situated at the long-wavelength edge of the reflection spectrum of the optical grating, thereby enabling the load mismatch resonance effect. Conversely, when the lasing wavelength is less than the central wavelength of the reflection spectrum, the load mismatch resonance effect cannot be generated.

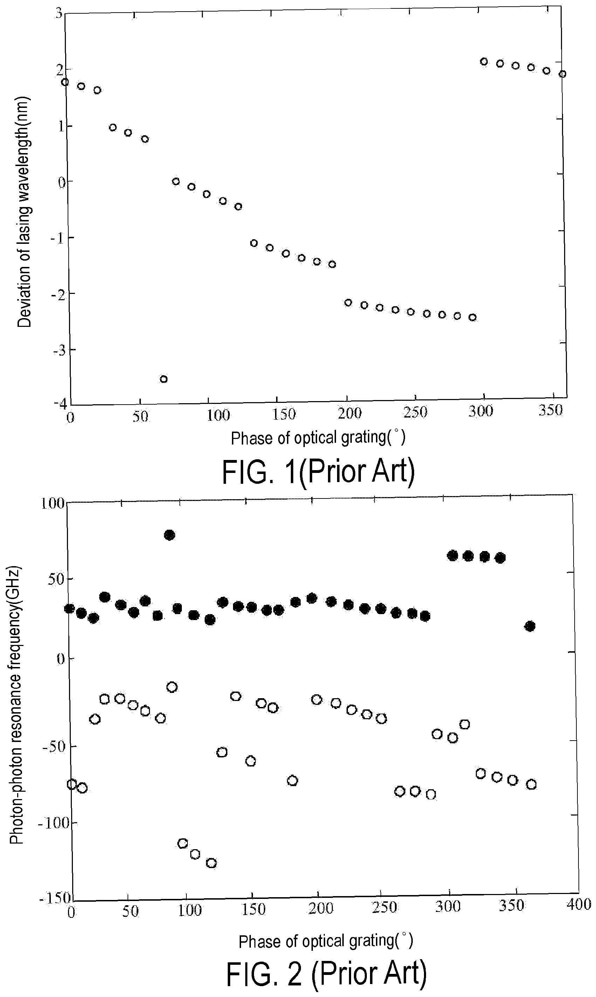

FIG. 1 illustrates a schematic diagram depicting the corresponding variation between the lasing wavelength and the optical grating phase in a semiconductor laser device. As evident from FIG. 1, the lasing wavelength is susceptible to significant fluctuations in response to changes in the phase of the end surface of the optical grating. Concurrently, the phase of the optical grating at its end surface exerts influence on the photon-photon resonance frequency, with varying optical grating phases resulting in substantial alterations to the photon-photon resonance frequency. FIG. 2 presents a schematic diagram demonstrating the corresponding variation between the photon-photon resonance frequency and the optical grating phase in a semiconductor laser device. As observed in FIG. 2, the solid dots • and hollow dots ∘ represent lasing wavelengths corresponding to side modes that exhibit frequency deviations relative to the primary lasing wavelength. The photon-photon resonance frequency associated with these modes undergoes considerable variations in response to changes in the optical grating phase.

In the manufacturing process of semiconductor laser devices, the end surface may be obtained through cleaving after dicing. Due to the typically imprecise control of the cleaving position of the end surface and the short period of the optical grating (approximately 200nm), the phase of the optical grating at the end surface is uncontrollable in practical devices. Consequently, in actual semiconductor laser devices employing a DFB+R structure, the phase of the optical grating at the HR end surface is random. This randomness renders the lasing wavelength and photon-photon resonance frequency of semiconductor laser devices utilizing the DFB+R structure uncontrollable. As a result, this phenomenon may lead to significant yield issues.

Furthermore, given that semiconductor laser devices employing a DFB+R structure require a certain degree of intracavity feedback, the front end surface necessitates a specific reflectivity (e.g., 3% reflectivity). Consequently, a Fabry-Perot (FP) cavity is formed between the front end surface and the HR rear end surface. Under normal temperature conditions, the gain peak of the semiconductor laser device is situated in proximity to the reflection spectrum of the optical grating, with the lasing wavelength primarily determined by the optical grating. However, at high or low temperatures, the gain peak of the semiconductor laser device may drift, deviating from the central wavelength of the reflection spectrum of the optical grating. In such instances, the gain of the FP modes formed by the semiconductor laser device end surfaces may exceed that of other intracavity modes, potentially causing the semiconductor laser device to generate FP mode lasing and resulting in multi-longitudinal mode oscillation.

Based on the foregoing, it requires an immediate solution to effectively enhance the modulation bandwidth of directly modulated semiconductor laser devices while simultaneously achieving a high yield rate, and to prevent the formation of a FP cavity due to reflections from the front and rear end surfaces of the laser device, which may lead to multi-longitudinal mode oscillations in the laser device under high or low temperature conditions.

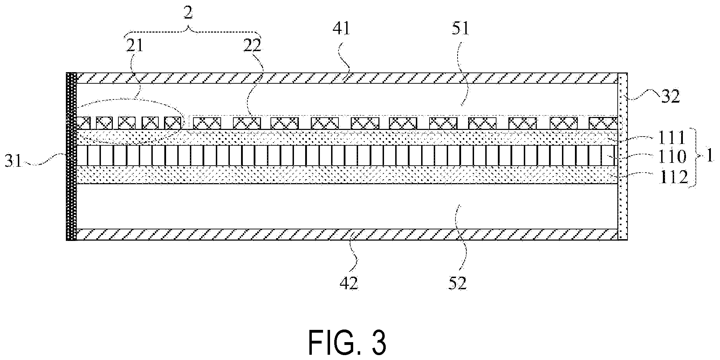

Based on the foregoing, please refer to FIG. 3, an embodiment of the present disclosure provides a semiconductor laser device. The semiconductor laser device includes an optical waveguide 1 and an optical grating 2 disposed on one side of the optical waveguide 1. The optical grating 2 includes a first optical grating portion 21 and a second optical grating portion 22 disposed side by side, wherein the first optical grating portion 21 and the second optical grating portion 22 work together to generate a photon-photon resonance and a load mismatch resonance effect.

The optical waveguide 1 is utilized to guide light waves, and for example, a ridge waveguide or a buried heterojunction waveguide may be adopted, etc. The embodiments of the present disclosure provides no limitation thereto.

The first optical grating portion 21 and the second optical grating portion 22 are arranged side by side, which means that the first optical grating portion 21 and the second optical grating portion 22 are arranged in the same layer, and the two may be formed by one-step etching on the same material layer. Optionally, the first optical grating portion 21 and the second optical grating portion 22 are directly connected. Alternatively, there is a gap between the first optical grating portion 21 and the second optical grating portion 22. The first optical grating portion 21 and the second optical grating portion 22 may be connected, for example, by a segment of material without an optical grating pattern.

In an embodiment of the disclosure, an optical grating 2 composed of a first optical grating portion 21 and a second optical grating portion 22 is disposed on one side of the optical waveguide 1. This configuration enables the utilization of both the first optical grating portion 21 and the second optical grating portion 22 to collectively determine the lasing wavelength and the photon-photon resonance frequency of the semiconductor laser device. This arrangement facilitates effective control of the lasing wavelength of the semiconductor laser device at the long-wavelength edge of the reflection spectrum of the optical grating, while simultaneously maintaining precise control of the photon-photon resonance frequency within a narrow range. Specifically, the second optical grating portion 22 plays a primary role in determining the lasing wavelength of the semiconductor laser device. Among them, the second optical grating part 22 plays a major role in determining the lasing wavelength of the semiconductor laser. Concurrently, the first optical grating portion 21 and the second optical grating portion 22 operate together to induce a load mismatch resonance effect when the lasing wavelength of the semiconductor laser device is positioned at the long-wavelength edge of the reflection spectrum of the first optical grating portion 21, thus effectively enhancing the bandwidth of the directly modulated semiconductor laser device. Furthermore, the present disclosed embodiment enables the enhancement of the bandwidth of the directly modulated semiconductor laser device through precise control of the photon-photon resonance frequency.

Furthermore, in an embodiment of the disclosure, the optical grating 2 includes a first optical grating portion 21 and a second optical grating portion 22 arranged side by side, which may be formed through one-step etching. Notwithstanding that the first optical grating portion 21 and the second optical grating portion 22 are of equivalent thickness, divergent optical grating coupling coefficients may be effectuated through etching optical gratings with disparate duty cycles, or employing optical gratings with dissimilar periods, wherein the dissimilar periods of optical gratings correspond to distinct optical grating orders (e.g., a first-order optical grating with a short period and a third-order optical grating with a long period).

From the above, the embodiment of the present disclosure may effectively improve the modulation bandwidth of the semiconductor laser device while avoiding other complex process treatments on the semiconductor laser device by designing the structure of optical grating 2, and accurately control the lasing wavelength and photon-photon resonance frequency of the semiconductor laser device, thereby achieving a higher yield rate.

The structures of the above-mentioned first optical grating portion 21 and the second optical grating portion 22 may be designed according to their functions.

For example, the first optical grating portion 21 and the second optical grating portion 22 may be first-order optical grating respectively. Alternatively, the first optical grating portion 21 and the second optical grating portion 22 may respectively be high-order optical grating. Alternatively, the first optical grating portion 21 may be a first-order optical grating, and the second optical grating portion 22 may be a higher-order optical grating. Alternatively, the first optical grating portion 21 may be a high-order optical grating, and the second optical grating portion 22 may be a first-order optical grating.

In an example, the first optical grating portion 21 is a first-order optical grating, and the second optical grating portion 22 is a high-order optical grating.

By way of example, the length of the first optical grating portion 21 and the length of the second optical grating portion 22 are different. For example, the length of the first optical grating portion 21 is shorter than the length of the second optical grating portion 22. In this way, the second optical grating portion 22 may play a major role in determining the lasing wavelength of the semiconductor laser device, and the first optical grating portion 21 is mainly configured to cause the lasing wavelength of the semiconductor laser device to generate a load mismatch resonance effect when being located at the long-wavelength edge of the reflection spectrum of the first optical grating portion 21.

For example, the coupling coefficient of the first optical grating portion 21 and the coupling coefficient of the second optical grating portion 22 are different. For example, the coupling coefficient of the first optical grating portion 21 is greater than the coupling coefficient of the second optical grating portion 22.

Herein, the coupling coefficients of the first optical grating portion 21 and the second optical grating portion 22 may be configured by designing their respective duty cycles and/or etching depths. For example, the width of the etched portion in each period of the second optical grating portion 22 is relatively smaller, thereby resulting in a shallower etching depth.

Optionally, the duty cycle of the first optical grating portion 21 is 50%, while the duty cycle of the second optical grating portion 22 is less than that of the first optical grating portion 21. As such, by employing a 50% duty cycle for the first optical grating portion 21, it is ensured that the first optical grating portion 21 possesses a relatively large coupling coefficient. By controlling the duty cycle of the second optical grating portion 22 to be less than 50%, for example, 40% or 30%, the coupling coefficient of the second optical grating portion 22 may be reduced in comparison to that of the first optical grating portion 21.

Optionally, the etching depth of the first optical grating portion 21 is smaller than the etching depth of the second optical grating portion 22. In this way, it may be ensured that the first optical grating portion 21 has a larger coupling coefficient, and the coupling coefficient of the second optical grating portion 22 is lower than that of the first optical grating portion 21.

It is comprehensible that in some exemplary embodiments, the product of the length and coupling coefficient of the first optical grating portion 21 is equivalent to the product of the length and coupling coefficient of the second optical grating portion 22. For instance, the product of the length and coupling coefficient of the first optical grating portion 21 satisfies the equation: κ₁L₁ = 1, wherein κ₁ represents the coupling coefficient of the first optical grating portion 21, and L₁ denotes the length of the first optical grating portion 21. The product of the length and coupling coefficient of the second optical grating portion 22 satisfies the equation: κ₂L₂ = 1, wherein κ₂ represents the coupling coefficient of the second optical grating portion 22, and L₂ denotes the length of the second optical grating portion 22.

By way of example, the period of the first optical grating portion 21 and the period of the second optical grating portion 22 are different. For example, the period of the first optical grating portion 21 is slightly smaller than the period of the second optical grating portion 22.

In some embodiments, the first optical grating portion 21 employs a first-order optical grating, wherein the optical grating period satisfies the following equation: 2*n_{eff}*L₁ = l₁; where *n_{eff}* represents the effective refractive index of the optical waveguide 1, L₁ denotes the period of the first optical grating portion 21, and l₁ signifies the center wavelength of the reflection spectrum of the first-order optical grating. The second optical grating portion 22 utilizes a third-order optical grating, wherein the optical grating period satisfies the following equation: 2*n_{eff}*L₂ = 3l₂; where *n_{eff}* represents the effective refractive index of the optical waveguide 1, L₂ denotes the period of the second optical grating portion 22, and l₂ signifies the center wavelength of the reflection spectrum of the third-order optical grating, with the condition that l₂ > l₁.

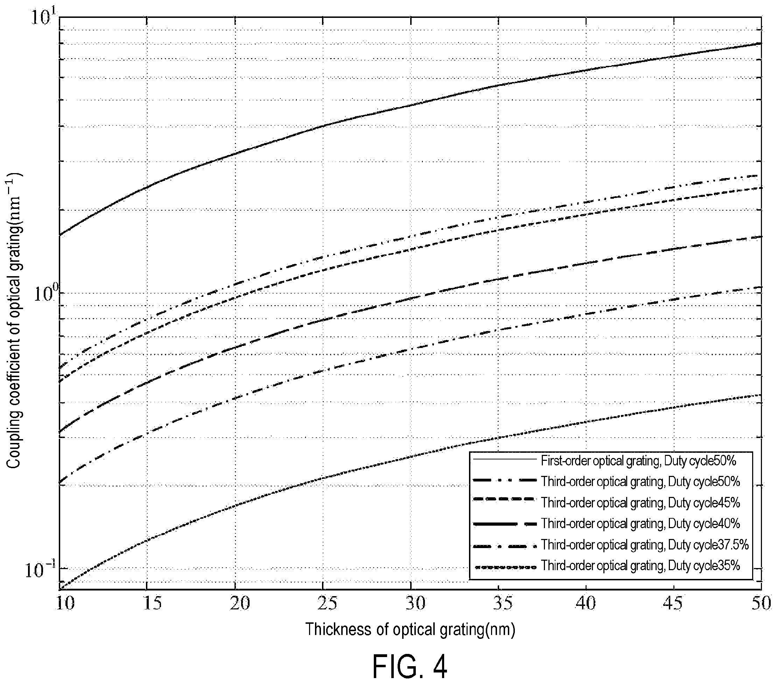

Based on this, please refer to FIG. 4 for understanding. FIG. 4 illustrates the coupling coefficients corresponding to first-order optical gratings and third-order optical gratings at various optical grating thicknesses. In examples where material layers of identical thickness are utilized to form the first optical grating portion 21 (first-order optical grating) and the second optical grating portion 22 (third-order optical grating), the first optical grating portion 21, employing a first-order optical grating with a duty cycle of 50%, may exhibit a relatively high coupling coefficient. The second optical grating portion 22, utilizing a third-order optical grating, may have a coupling coefficient that varies in accordance with changes in the duty cycle. Consequently, for the first optical grating portion 21 and the second optical grating portion 22 formed from optical grating material layers of equivalent thickness, the first optical grating portion 21 may employ a first-order optical grating with a 50% duty cycle to achieve a relatively high coupling coefficient. Conversely, the second optical grating portion 22 may utilize a higher-order optical grating to reduce the coupling coefficient, with further adjustment of the coupling coefficient possible through modification of the duty cycle.

Based on the foregoing, the present disclosure does not impose limitations on the order or specific structure (including positioning) of the first optical grating portion 22 and the second optical grating portion 22. The objective is to ensure that the first optical grating portion 22 and the second optical grating portion 22 may achieve precise control of the lasing wavelength and photon-photon resonance frequency through the design of appropriate optical grating parameters.

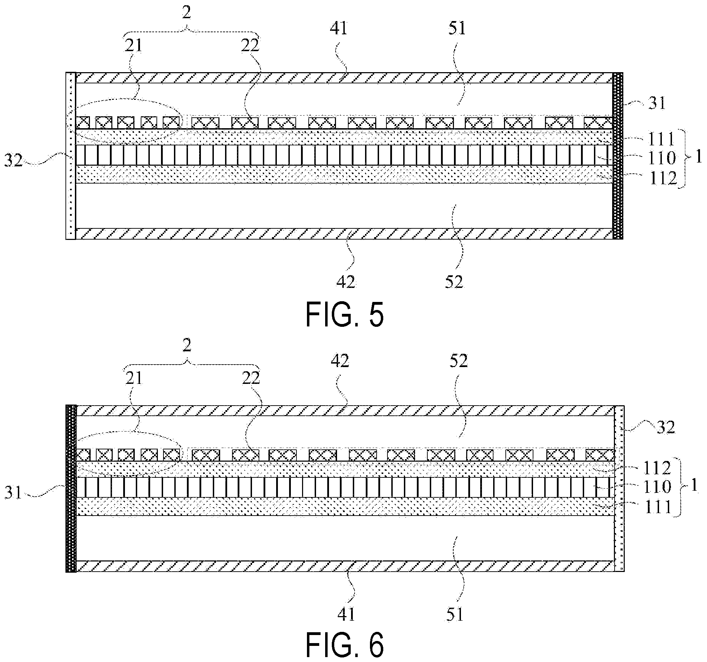

Please refer to FIG. 3 and FIG. 5 for understanding. In some embodiments, the semiconductor laser device has a light output terminal and a light reflection terminal that are positioned relative to each other. The end surface of the light output terminal, for example, is the front end surface of the semiconductor laser device, used for outputting the modulated laser. The end surface of the light reflection terminal, for example, is the rear end surface of the semiconductor laser device, utilized for reflecting the optical signals entering the cavity of the semiconductor laser device. The semiconductor laser device further includes an anti-reflection (AR) film 31 disposed on the end surface of the light output terminal, and a high reflectivity (FR) film 32 disposed on the end surface of the light reflection terminal. The two terminals of the optical waveguide 1 are coupled with the AR film 31 and the HR film 32 respectively. Therein, the first optical grating portion 21 is positioned on one side of the second optical grating portion 22 that is closer to the HR film 32; alternatively, the first optical grating portion 21 is positioned on one side of the second optical grating portion 22 that is closer to the AR film 31. In other words, the positions of the AR film 31 and the HR film 32 are relative, and either the first optical grating portion 21 or the second optical grating portion 22 may be positioned closer to the AR film 31.

Optionally, the AR film 31 and the HR film 32 may be formed through coating, sputtering or electroplating processes.

In an embodiment of the disclosure, there are no reflectivity requirements for the end surface at the light output terminal of the semiconductor laser device. In other words, this semiconductor laser device does not need to utilize the end surface at the light output terminal for optical feedback. Consequently, the embodiment of the disclosure allows for the application of the AR film 31 on the end surface at the light output terminal. Even if the optical reflection of the AR film 31 is zero, the semiconductor laser device may still generate photon-photon resonance through the aforementioned optical grating structure. This approach effectively prevents the formation of a FP cavity due to optical reflection at the front and rear end surfaces of the semiconductor laser device, which could otherwise cause the semiconductor laser device to generate multi-longitudinal mode oscillation at high or low temperatures. The semiconductor laser device provided in an embodiment of the disclosure may effectively achieve single-longitudinal mode operation.

It should be noted that, in conjunction with FIG. 5 and FIG. 6, the semiconductor laser device further includes a first-type electrode layer 41 and a second-type electrode layer 42 disposed in relative positions. Specifically, one of the first-type electrode layer 41 and the second-type electrode layer 42 is situated on one side of the optical grating 2 facing away from the optical waveguide 1, while the other is situated on one side of the optical waveguide 1 facing away from the optical grating 2. In other words, in an embodiment of the present disclosure, the optical grating 2 may be positioned on either the upper or lower side of the optical waveguide 1, or alternatively stated, the optical grating 2 may be situated on one side of the optical waveguide 1 proximate to the first-type electrode layer 41 or on one side proximate to the second-type electrode layer 42. The embodiment of the present disclosure does not impose any limitations in this regard.

In an embodiment of the present disclosure, current may be injected into the first optical grating portion 21 and the second optical grating portion 22 of the optical grating 2 through the first-type electrode layer 41 and the second-type electrode layer 42, thereby generating optical gain and enhancing the light extraction efficiency of the semiconductor laser device.

Optionally, in reference to FIG. 5 and FIG. 6, the semiconductor laser device further includes a first-type coating layer 51 and a second-type coating layer 52 positioned relative to each other. Specifically, the first-type coating layer 51 is situated on one side of the first-type electrode layer 41 proximate to the optical waveguide 1, while the second-type coating layer 52 is situated on one side of the second-type electrode layer 42 proximate to the optical waveguide 1. Depending on the positioning of the optical grating 2, the optical grating 2 may be correspondingly located either between the optical waveguide 1 and the first-type coating layer 51, or between the optical waveguide 1 and the second-type coating layer 52.

It is understood that the optical waveguide 1 typically includes a light transmitting layer 110 and a first-type confinement layer 111 and a second-type confinement layer 112 respectively positioned on opposite sides of the light transmitting layer 110; wherein the first-type confinement layer 111 is situated on one side of the light transmitting layer 110 proximal to the first-type electrode layer 41, and the second-type confinement layer 112 is situated on one side of the light transmitting layer 110 proximal to the second-type electrode layer 42. The optical grating 2 is correspondingly positioned on one side of either the first-type confinement layer 111 or the second-type confinement layer 112 facing away from the light transmitting layer 110.

Herein, the light transmitting layer 110 is exemplified as an active or passive multiple quantum well layer. The first-type confinement layer 111 and the second-type confinement layer 112 are exemplified as corresponding separate confinement heterostructure (SCH) layers.

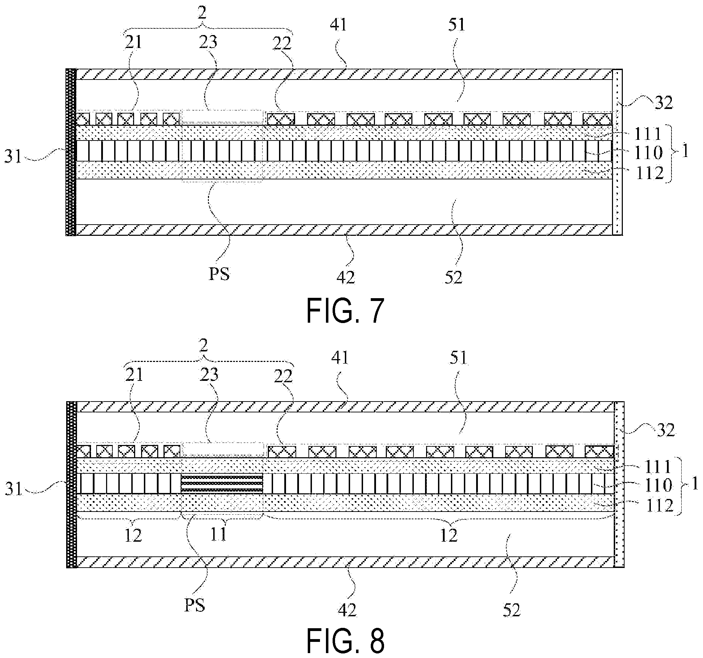

Please refer to FIG. 7. In some embodiments, there exists a gap 23 between the first optical grating portion 21 and the second optical grating portion 22. The optical waveguide 1 incorporates a phase shift region PS. The region occupied by the phase shift region PS overlaps with the orthogonal projection of the aforementioned gap 23 between the first optical grating portion 21 and the second optical grating portion 22 on the optical waveguide 1. Consequently, after traversing the phase shift region PS, the optical signal transmitted through the optical waveguide 1 may be controlled to generate a specific phase shift, such as a phase difference of 2kπ+π/2 or other fixed phase values.

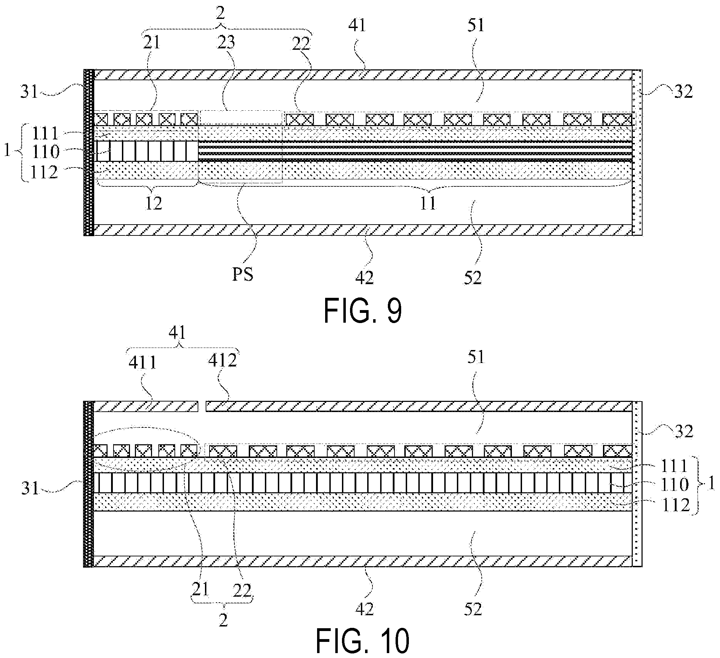

Please refer to FIG. 8 and FIG. 9. In some embodiments, the optical waveguide 1 includes a passive optical waveguide portion 11 and an active optical waveguide portion 12 coupled to each other. The distinction between the passive optical waveguide portion 11 and the active optical waveguide portion 12 lies in their ability to generate optical gain for the transmitted optical signals. Specifically, the active optical waveguide portion 12 is capable of producing optical gain for the transmitted optical signals, whereas the passive optical waveguide portion 11 lacks this capability.

Optionally, referring to FIG. 8, the phase shift region PS includes a passive optical waveguide portion 11. In other words, the phase shift region PS may be formed by repurposing the passive optical waveguide portion 11 within the optical waveguide 1.

Optionally, referring to FIG. 9, the gap 23 between the first optical grating portion 21 and the second optical grating portion 22, as well as the orthogonal projection of the second optical grating portion 22 on the optical waveguide 1, are located within the region of the passive optical waveguide portion 11.

It is noteworthy that, in some embodiments, the first-type electrode layer 41 is, for example, a P-type electrode layer, and the second-type electrode layer 42 is, for example, an N-type electrode layer. Correspondingly, the first-type coating layer 51 may be a P-type semiconductor layer, such as a P-InP (indium phosphide) or P-InGaAsP layer. The second-type coating layer 52 may be an N-type semiconductor layer, such as an N-InP (indium phosphide) or P-InGaAsP layer. Within the optical waveguide 1, the first-type confinement layer 111 may be a P-type confinement layer, while the second-type confinement layer 112 may be an N-type confinement layer.

For ease of description, in the following embodiments, the first-type electrode layer 41 is exemplified as a P-type electrode layer, and the optical grating 2 is positioned between the optical waveguide 1 and the first-type coating layer 51. Embodiments wherein the optical grating 2 is situated between the optical waveguide 1 and the second-type coating layer 52 may be adaptively understood based on the following embodiments.

Referring to FIG. 10, in some embodiments, the P-type electrode layer includes: a first electrode 411 and a second electrode 412, which are insulated from each other; wherein the orthogonal projection of the first electrode 411 on the optical waveguide 1 at least partially overlaps with the orthogonal projection of the first optical grating portion 21 on the optical waveguide 1. The orthogonal projection of the second electrode 412 on the optical waveguide 1 at least partially overlaps with the orthogonal projection of the second optical grating portion 22 on the optical waveguide 1.

Optionally, the orthogonal projection of the first electrode 411 on the optical waveguide 1 overlaps with the orthogonal projection of the first optical grating portion 21 on the optical waveguide 1. The orthogonal projection of the second electrode 412 on the optical waveguide 1 overlaps with the orthogonal projection of the second optical grating portion 22 on the optical waveguide 1.

Based on the foregoing, in the embodiment of the present disclosure, the first optical grating portion 21 and the second optical grating portion 22 of the optical grating 2 may share the second-type electrode layer 42 (i.e., the N-type electrode layer). Furthermore, in the embodiment of the disclosure, the first-type electrode layer 41 (i.e., the P-type electrode layer) is configured as a first electrode 411 and a second electrode 412 relatively independent of each other. This configuration enables the control of current injection magnitude into the first optical grating portion 21 utilizing the first electrode 411, and the control of current injection magnitude into the second optical grating portion 22 utilizing the second electrode 412. Consequently, through independent current injection control of the first optical grating portion 21 and the second optical grating portion 22, it is possible to separately regulate the requisite optical gain produced by the first optical grating portion 21 and the second optical grating portion 22 on the optical signal.

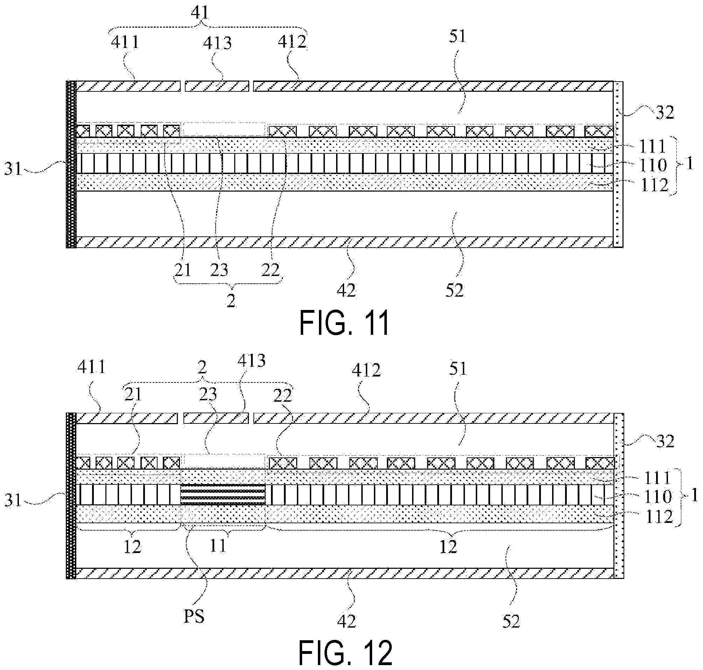

Please refer to FIG. 11. In some embodiments, there is a gap 23 between the first optical grating portion 21 and the second optical grating portion 22. The p-type electrode layer further includes a third electrode 413, which is electrically insulated from both the first electrode 411 and the second electrode 412. The orthogonal projection of the third electrode 413 on the optical waveguide 1 at least partially overlaps with the orthogonal projection of the aforementioned gap 23 on the optical waveguide 1.

Optionally, the orthogonal projection of the third electrode 413 on the optical waveguide 1 overlaps with the orthogonal projection of the aforementioned gap 23 on the optical waveguide 1.

In an embodiment of the disclosure, the third electrode 413 may be utilized to control the optical signal transmitted through the optical waveguide 1, to produce some phase shift after passing through the region corresponding to the aforementioned gap 23.

Optionally, referring to FIG. 12, the optical waveguide 1 includes a phase shift region PS. The orthogonal projection of the third electrode 413 on the optical waveguide 1 overlaps with the orthogonal projection of the phase shift region PS on the optical waveguide 1. As such, the third electrode 413 may be utilized to control the magnitude of current injected into the phase shift region PS, thereby controlling the optical signal transmitted through the optical waveguide 1 to generate some phase shift after passing through the phase shift region PS.

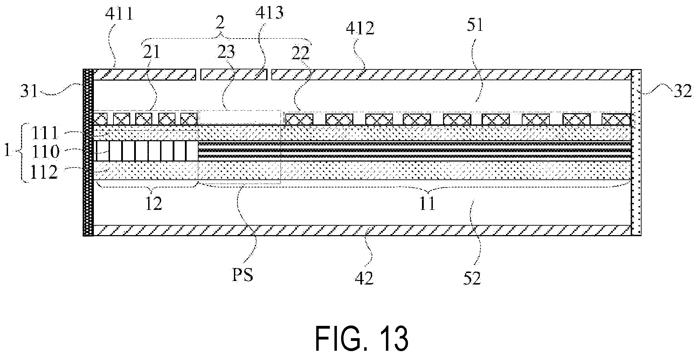

Optionally, referring to FIG. 13, the optical waveguide 1 includes a passive waveguide portion 11. The gap 23 between the first optical grating portion 21 and the second optical grating portion 22, as well as the orthogonal projection of the second optical grating portion 22 on the optical waveguide 1, are located within the region of the passive waveguide portion 11. The orthogonal projections of the third electrode 413 and the second electrode 412 on the optical waveguide 1 are situated within the region of the passive waveguide portion 11.

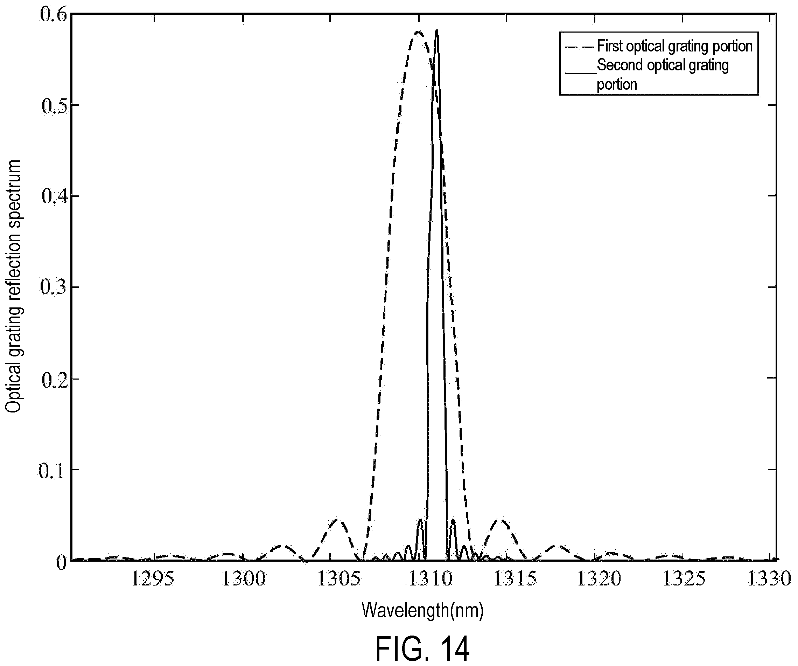

Based on the foregoing, the semiconductor laser device provided in the embodiment of the disclosure, as described in some of the aforementioned embodiments, may obtain reflection spectra of the first optical grating portion 21 and the second optical grating portion 22 in the optical grating 2 thereof, as illustrated in FIG. 14. In FIG. 14, the dashed line represents the reflection spectrum of the first optical grating portion 21, while the solid line represents the reflection spectrum of the second optical grating portion 22. As evident from FIG. 14, the reflection spectrum of the first optical grating portion 21 is broader than that of the second optical grating portion 22. Furthermore, the center wavelength corresponding to the reflection spectrum of the first optical grating portion 21 is 1310 nm, whereas the center wavelength corresponding to the reflection spectrum of the second optical grating portion 22 is 1311 nm, indicating that the center wavelength of the first optical grating portion 21 is shorter than that of the second optical grating portion 22. Consequently, by utilizing the distributed feedback effect of two distinct optical grating portions (the first optical grating portion 21 and the second optical grating portion 22) within the optical grating 2, the lasing wavelength may be positioned near the center wavelength corresponding to the reflection spectrum of the second optical grating portion 22, which is also located at the long-wavelength edge of the first optical grating portion 21, thereby achieving a load mismatch resonance effect.

Furthermore, with regard to the DFB laser device in related technologies, a common issue is that the lasing wavelength varies with changes in the phase of the optical grating at the end surface. However, the semiconductor laser device provided in the embodiment of the present disclosure, which configures the optical grating 2 as the first optical grating portion 21 and the second optical grating portion 22 arranged side by side, may significantly reduce the impact of variations in the phase of optical grating end surface on the lasing wavelength.

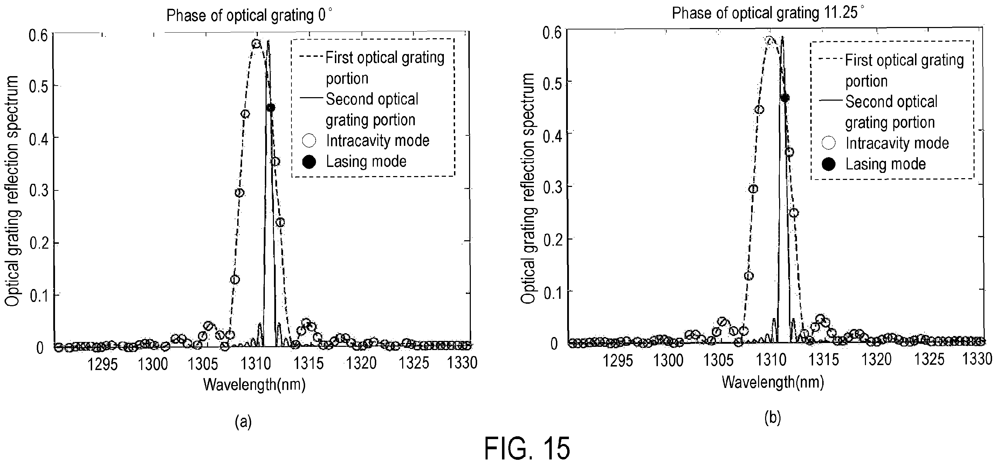

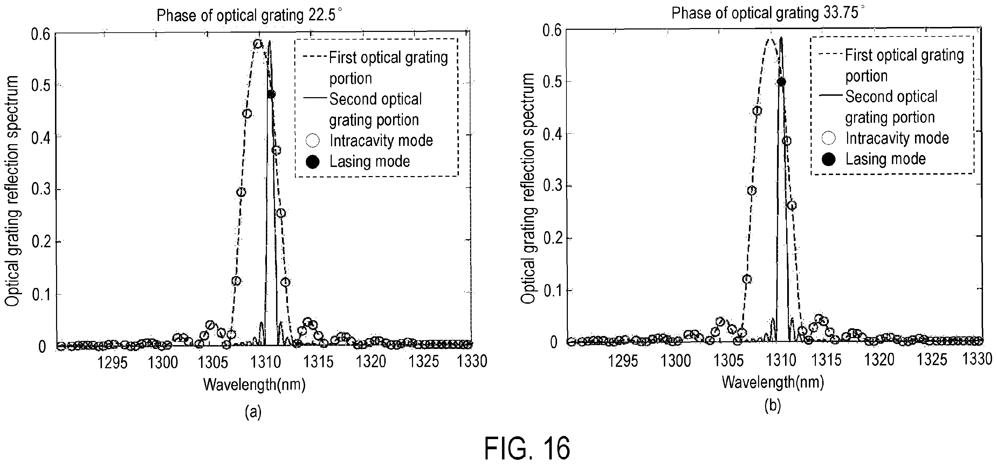

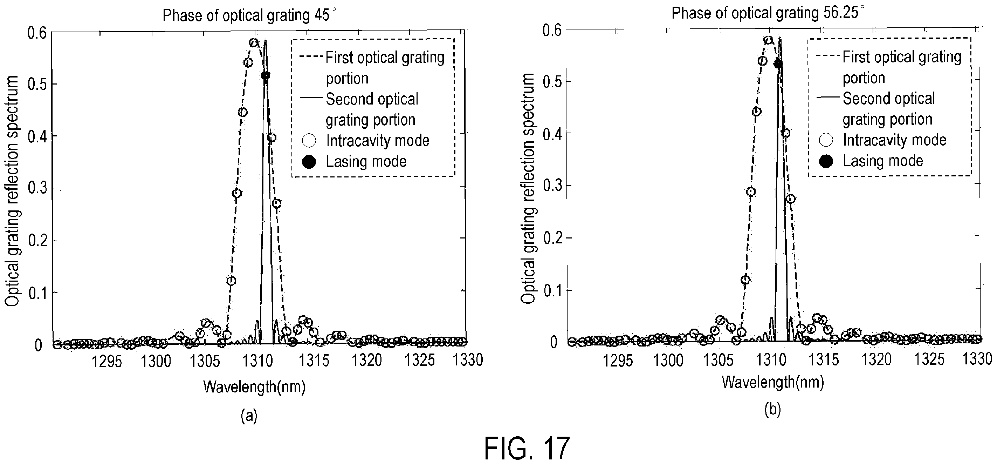

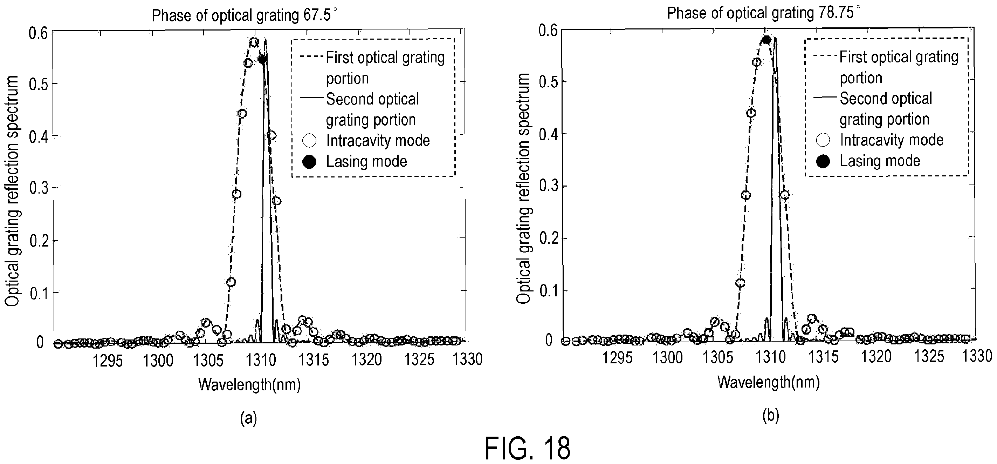

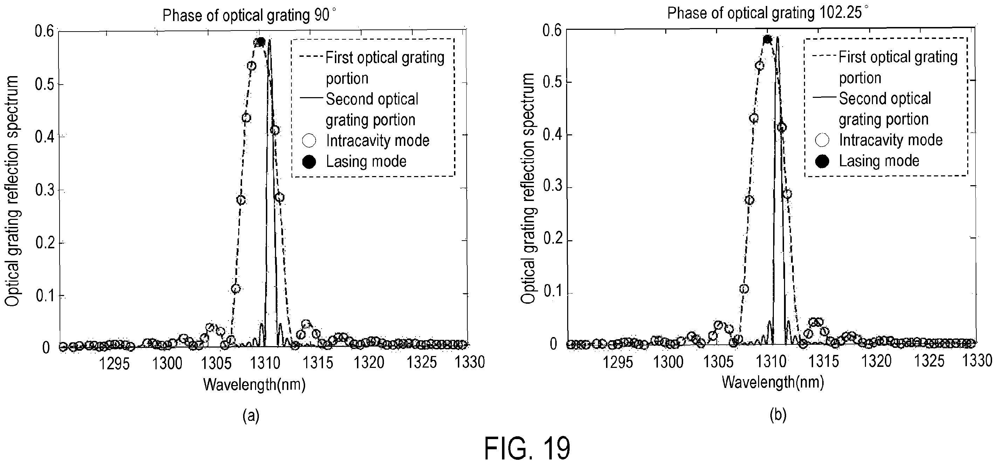

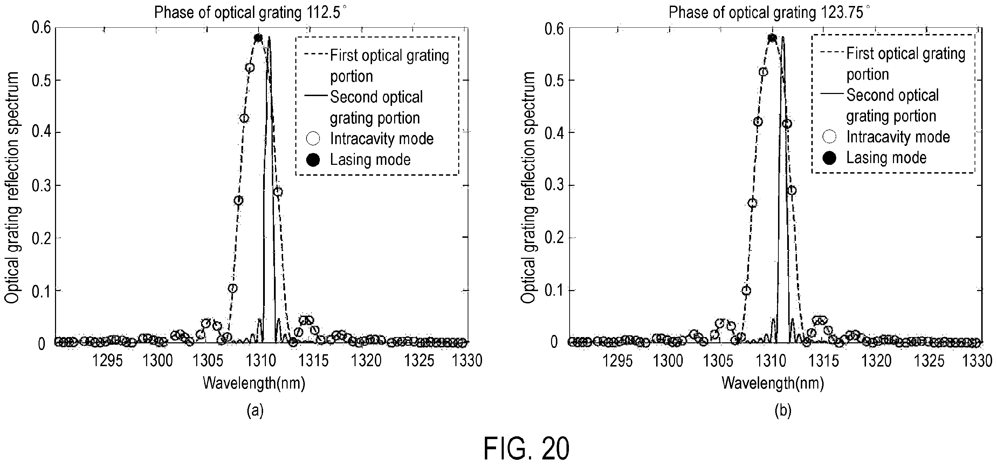

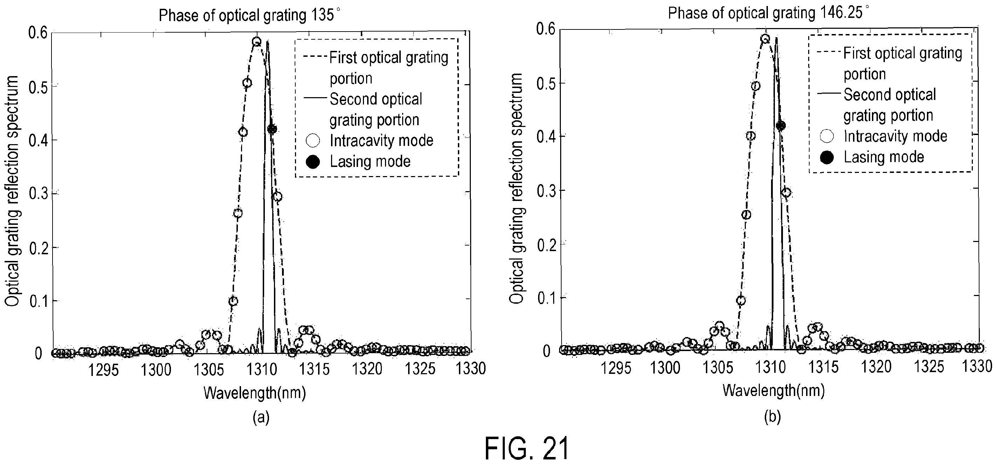

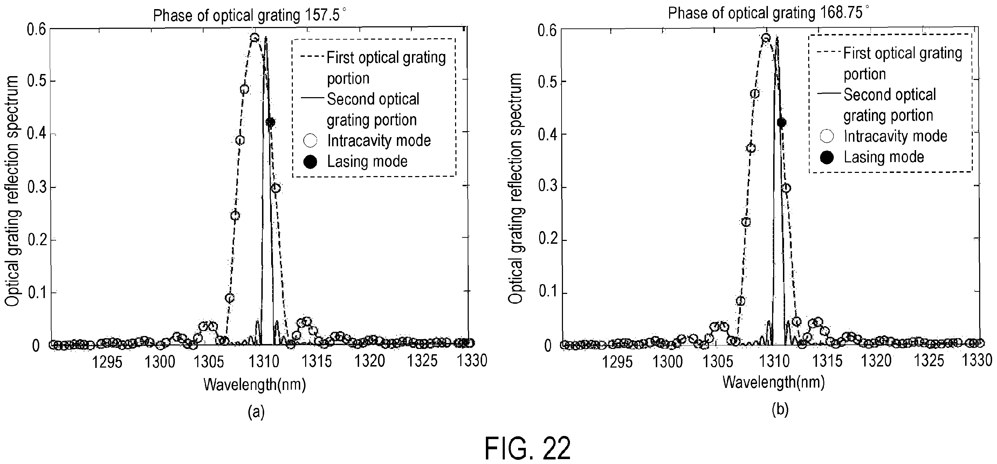

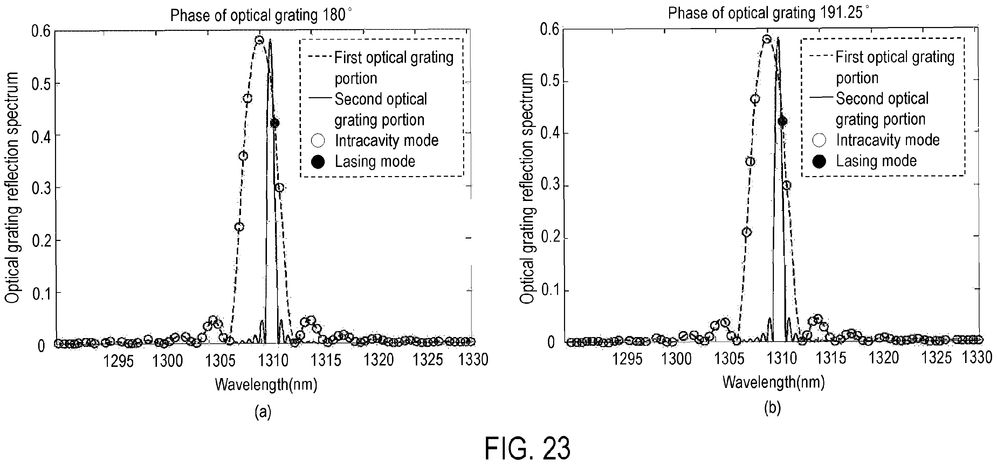

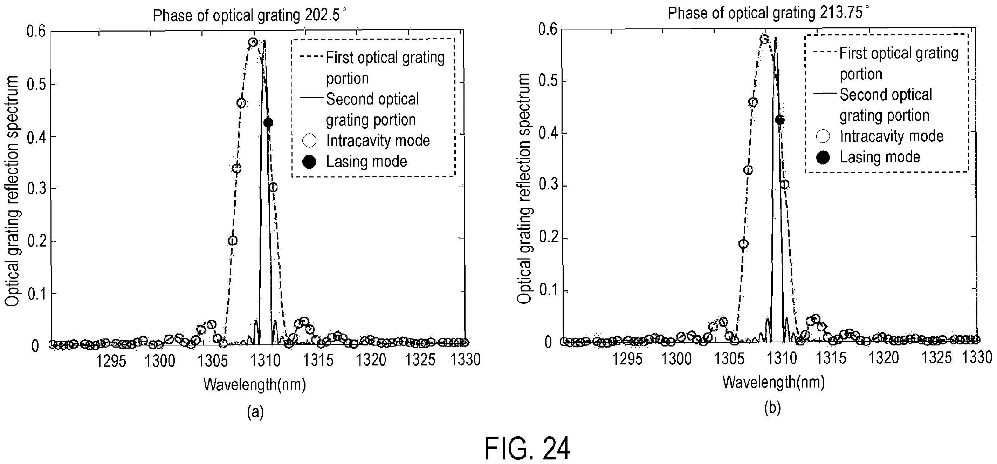

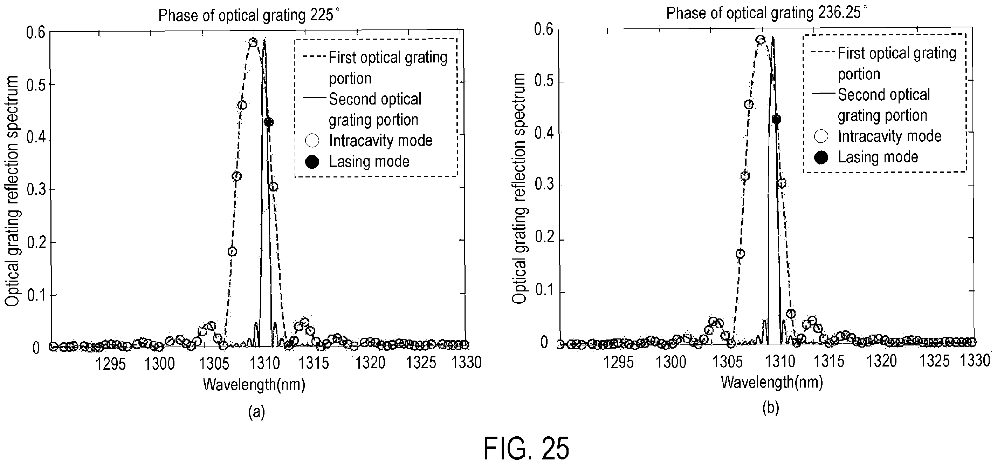

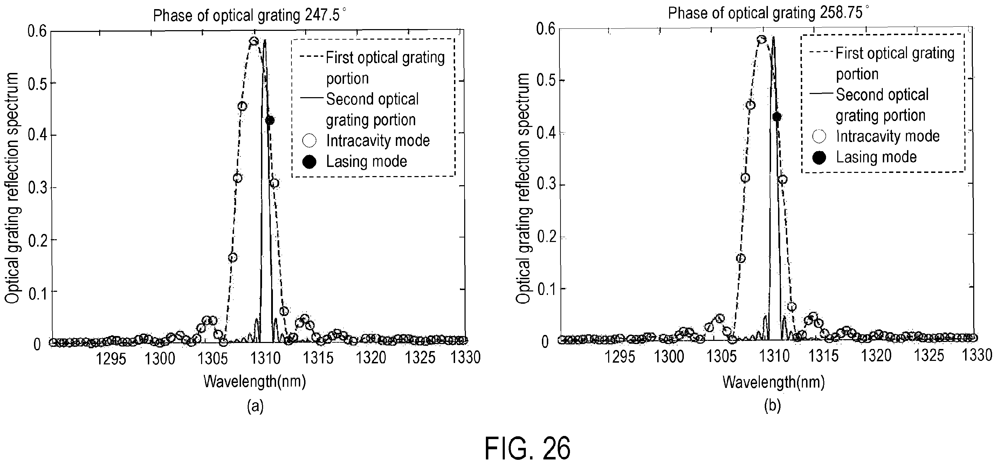

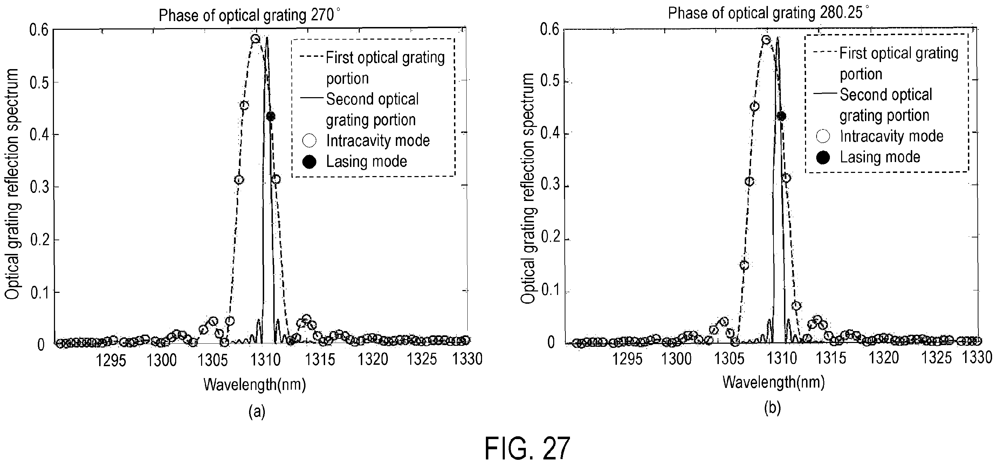

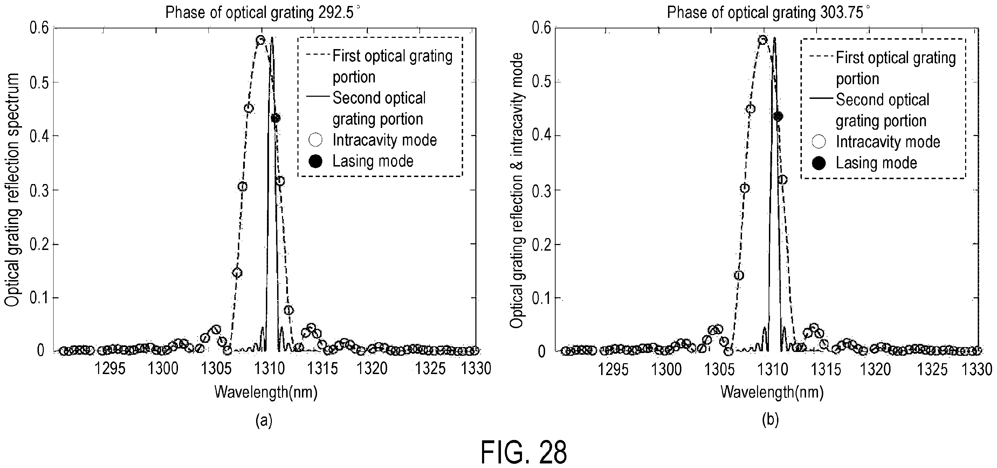

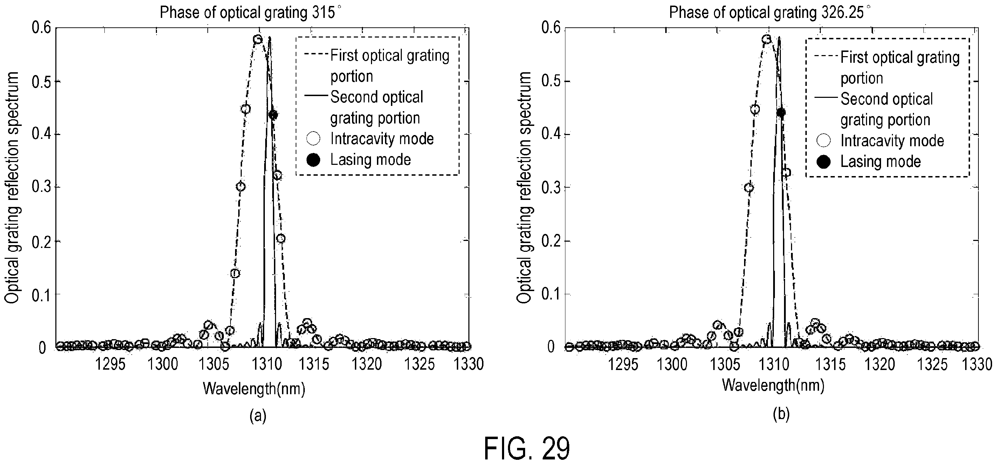

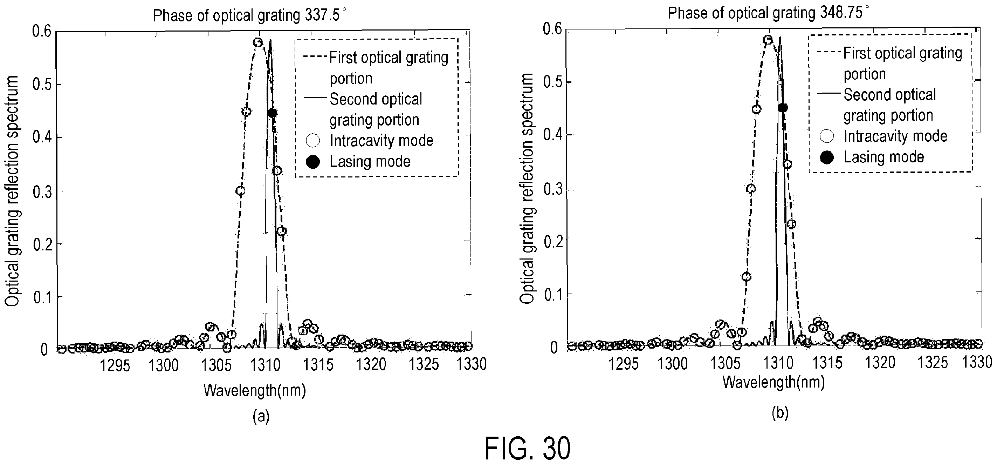

Exemplarily, FIG. 15 to FIG. 30 illustrate the variation in the lasing wavelength of the semiconductor laser device as the phase of the optical grating corresponding to the light reflection terminal (i.e., the HR terminal) changes from 0° to 360°. Therein, the dashed line represents the reflection spectrum of the first optical grating portion 21, while the solid line represents the reflection spectrum of the second optical grating portion 22. Hollow dots (∘) indicate intracavity modes, and solid dots (•) denote the position of the lasing wavelength. As evidenced by FIG. 15 to FIG. 30, despite some variation in the lasing wavelength of the semiconductor laser device as the phase of the optical grating corresponding to the light reflection terminal (i.e., the HR terminal) changes from 0° to 360°, in the vast majority of cases, the lasing wavelength remains positioned at the long-wavelength edge of the reflection spectrum corresponding to the first optical grating portion 21. This demonstrates that the semiconductor laser device provided in the embodiment of the present disclosure may ensure the generation of a load mismatch resonance effect within the cavity.

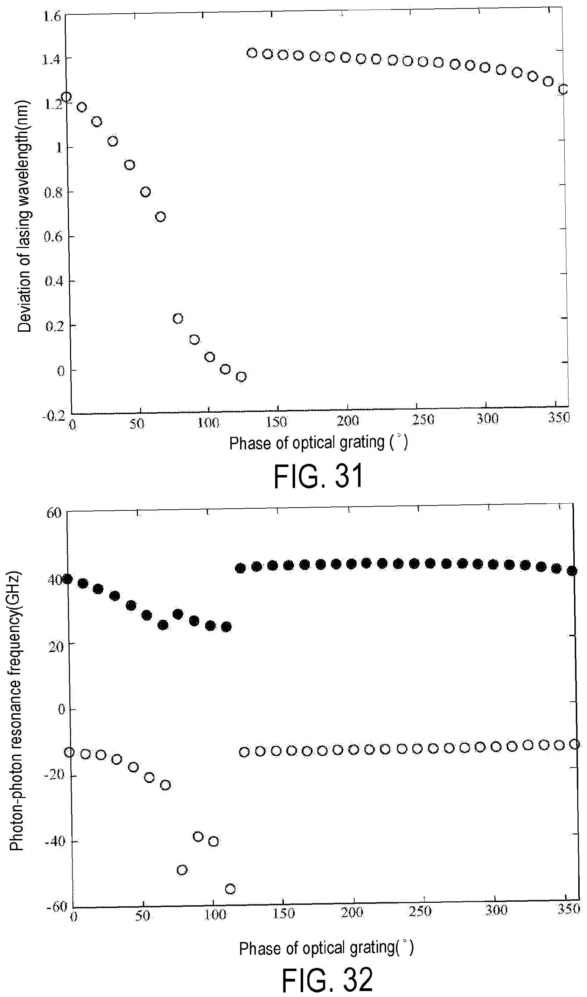

FIG. 31 is a schematic diagram of the corresponding changes between lasing wavelength and optical grating phase in a semiconductor laser device in an embodiment of the disclosure. The horizontal axis represents the optical grating phase corresponding to the light reflection terminal (i.e., the HR terminal), while the vertical axis represents the deviation of the lasing wavelength from the center wavelength of the reflection spectrum of the first optical grating portion 21. From FIG. 31, it may be visually observed that as the optical grating phase varies from 0° to 360°, the vertical axis indicates the position of the lasing wavelength relative to the center wavelength of the reflection spectrum of the first optical grating portion 21. A positive value indicates that the lasing wavelength is greater than the center wavelength of the reflection spectrum of the first optical grating portion 21, which means the lasing wavelength is at the long-wavelength edge of the reflection spectrum of the first optical grating portion 21.

FIG. 32 is a schematic diagram showing the corresponding changes between the photon-photon resonance frequency and the optical grating phase in a semiconductor laser device provided in an embodiment of the disclosure. Therein, the curve denoted by solid dots • represents the frequency deviation of the side mode located on the short-wavelength side of the lasing wavelength relative to the lasing wavelength, while the curve denoted by hollow dots ∘ represents the frequency deviation of the side mode located on the long-wavelength side of the lasing wavelength relative to the lasing wavelength. As may be observed from FIG. 32, the frequency deviation of the side mode located on the short-wavelength side of the lasing wavelength relative to the lasing wavelength may be maintained at approximately 40 GHz in most instances. This demonstrates that the semiconductor laser device provided in the embodiment of the present disclosure may exert relatively stable control over the photon-photon resonance frequency.

The embodiment of the disclosure further provides a method for preparing a semiconductor laser device, which is used to prepare the semiconductor laser device described in some of the aforementioned embodiments. The preparation method includes the following steps.

The optical grating material layer with uniform thickness is formed on one side of the optical waveguide. Through a one-step etching process, a first optical grating portion and a second optical grating portion are formed and arranged side by side. The first optical grating portion and the second optical grating portion collectively constitute an optical grating. The coupling coefficient of the first optical grating portion is greater than the coupling coefficient of the second optical grating portion.

Optionally, the period of etching the first optical grating portion is shorter than the period of etching the second optical grating portion.

Optionally, the duty cycle of etching the first optical grating portion differs from the duty cycle of etching the second optical grating portion.

Optionally, the etching depth of the first optical grating portion is greater than the etching depth of the second optical grating portion.

The period, duty cycle, or etching depth of the first optical grating portion differs from the period, duty cycle, or etching depth of the second optical grating portion. Consequently, the optical grating coupling coefficient of the first optical grating portion differs from the optical grating coupling coefficient of the second optical grating portion.

In an embodiment of the present disclosure, a first optical grating portion and a second optical grating portion (i.e., two distinct optical gratings) with different characteristics such as varying lengths, coupling coefficients, and periods may be fabricated on an optical grating epitaxial layer utilizing a one-step etching process. Moreover, this preparation method enables precise control of the phase shift between the first optical grating portion and the second optical grating portion, thereby addressing the issue of uncontrollable phase shift errors that arise in related technologies due to the necessity of employing different etching processes for optical gratings with diverse performance characteristics. This approach is conducive to enhancing the yield rate of semiconductor laser devices.

It may be understood that the fabrication process for optical gratings typically involves the following steps. A photoresist is applied to an epitaxial wafer, and the optical grating pattern is obtained through holographic or electron beam exposure, or nanoimprint lithography. Then, the pattern is subsequently transferred to the optical grating material layer through either wet etching (e.g., using bromic acid) or dry etching (e.g., RIE or ICP) to form an optical grating. Therefore, the main parameters affecting the coupling coefficient of the optical grating are depth and duty cycle.

In an embodiment of the disclosure, the optical grating includes a first optical grating portion and a second optical grating portion, wherein the coupling coefficients of the first optical grating portion and the second optical grating portion differ. Consequently, the required etching depths or duty cycles for these portions are dissimilar. The present embodiment employs a one-step etching process to form both the first optical grating portion and the second optical grating portion. This approach mitigates the risk of alignment errors between the first optical grating portion and the second optical grating portion that might arise due to precision control issues inherent in conventional etching techniques. In other words, this method prevents the occurrence of uncontrollable phase shift errors between the first optical grating portion and the second optical grating portion.

In the description provided in this specification, the technical features of the aforementioned embodiments may be combined in any manner. For the sake of brevity, not all possible combinations of the technical features of the above embodiments have been described. However, insofar as these combinations of technical features do not present any contradictions, they should be considered as falling within the scope of this specification.

The aforementioned embodiments merely express several implementations of the present disclosure. While their descriptions are relatively specific and detailed, they should not be construed as limitations on the scope of patent protection sought. It should be noted that for those skilled in the art, various modifications and improvements can be made without departing from the conceptual premise of this disclosure, all of which fall within the scope of protection of this disclosure. Therefore, the scope of patent protection for this disclosure shall be determined by the appended claims.

## Claims

1. A semiconductor laser device, **characterized in that**, comprising an optical waveguide and an optical grating disposed on one side of the optical waveguide,
wherein the optical grating comprises a first optical grating portion and a second optical grating portion disposed side by side.

2. The semiconductor laser device according to claim 1, **characterized in that**, a length of the first optical grating portion is less than a length of the second optical grating portion.

3. The semiconductor laser device according to claim 1, **characterized in that**, a coupling coefficient of the first optical grating portion is greater than a coupling coefficient of the second optical grating portion.

4. The semiconductor laser device according claim 1, **characterized in that**, a period of the first optical grating portion is shorter than a period of the second optical grating portion.

5. The semiconductor laser device according to claim 1, **characterized in that**, the semiconductor laser device has a light output terminal and a light reflection terminal that are arranged opposite to each other,
wherein the semiconductor laser device further comprises an anti-reflection film arranged on an end surface of the light output terminal, and a reflection film arranged on an end surface of the light reflection terminal,
two terminals of the optical waveguide are respectively coupled to the anti-reflection film and the reflection film,
wherein the first optical grating portion is located on one side of the second optical grating portion close to the reflection film, or
the first optical grating portion is located on one side of the second optical grating portion close to the anti-reflection film.

6. The semiconductor laser device according to claim 1, **characterized in that**, there is a gap between the first optical grating portion and the second optical grating portion,
wherein the optical waveguide comprises a phase shift region,
the phase shift region is located in an area overlapping with an orthogonal projection of the gap on the optical waveguide.

7. The semiconductor laser device according to claim 6, **characterized in that**, the phase shift region comprises a passive optical waveguide portion.

8. The semiconductor laser device according to claim 1, **characterized in that**, the optical waveguide comprises an active optical waveguide portion and a passive optical waveguide portion coupled to each other,
wherein an orthogonal projection of the gap and an orthogonal projection of the second optical grating portion on the optical waveguide are located in a region where the passive optical waveguide portion is located.

9. The semiconductor laser device according to claim 1, **characterized in that**, the semiconductor laser device further comprises: a first-type electrode layer and a second-type electrode layer disposed opposite to each other,
wherein one of the first-type electrode layer and the second-type electrode layer is located on one side of the optical grating away from the optical waveguide, and the other is located on one side of the optical waveguide away from the optical grating.

10. The semiconductor laser device according to claim 9, **characterized in that**, the first-type electrode layer is a P-type electrode layer, wherein the P-type electrode layer comprises: a first electrode and a second electrode that are insulated,
wherein an orthogonal projection of the first electrode on the optical waveguide at least partially overlaps with an orthogonal projection of the first optical grating portion on the optical waveguide,
an orthogonal projection of the second electrode on the optical waveguide at least partially overlaps with an orthogonal projection of the second optical grating portion on the optical waveguide.

11. The semiconductor laser device according to claim 10, **characterized in that**, there is a gap between the first optical grating portion and the second optical grating portion,
wherein the P-type electrode layer further comprises a third electrode insulated from the first electrode and the second electrode respectively,
an orthogonal projection of the third electrode on the optical waveguide at least partially overlaps with an orthogonal projection of the gap on the optical waveguide.

12. The semiconductor laser device according to claim 11, **characterized in that**, the optical waveguide comprises a phase modulation portion,
wherein the orthogonal projection of the third electrode on the optical waveguide overlaps with an orthogonal projection of the phase modulation portion on the optical waveguide.

13. The semiconductor laser device according to claim 11, **characterized in that**, the optical waveguide comprises a passive optical waveguide portion,
wherein an orthogonal projection of the gap and the orthogonal projection of the second optical grating portion on the optical waveguide are located in a region where the passive optical waveguide portion is located,
the orthogonal projections of the third electrode and the second electrode on the optical waveguide are located in the region where the passive optical waveguide portion is located.

14. A method for preparing a semiconductor laser device, **characterized in that**, comprising:
forming an optical grating material layer with a uniform thickness on one side of an optical waveguide,
forming a first optical grating portion and a second optical grating portion arranged side by side through a one-step etching process,
wherein the first optical grating portion and the second optical grating portion together constitute an optical grating,
and a coupling coefficient of the first optical grating portion is greater than a coupling coefficient of the second optical grating portion.

15. The method for preparing the semiconductor laser device according to claim 14, a period of etching the first optical grating portion is shorter than a period of etching the second optical grating portion.

16. The method for preparing the semiconductor laser device according to claim 14, a duty ratio of etching the first optical grating portion is different from a duty ratio of etching the second optical grating portion.

17. The method for preparing the semiconductor laser device according to claim 14, a depth of etching the first optical grating portion is greater than a depth of etching the second optical grating portion.
